# EUROPEAN PATENT APPLICATION

(11) **EP 3 010 323 A2**
(43) Date of publication of application: **20.04.2016**
(21) Application number: 15189831.9
(22) Date of filing: 14.10.2015
(51) Int. Cl.: H05K 7/20

(54) **EFFICIENT AIR COOLING OF VARYING LOAD ELECTRONICS**

(30) Priority: 16.10.2014 US 201414515888
(71) Applicant: Hamilton Sundstrand Corporation, Charlotte, NC 28217 (US)
(72) Inventor: SEVERSON, Mark Hamilton, Rockford, IL 61114 (US); METZLER, Mark W., Davis, IL 61019 (US)
(74) Representative: Leckey, David Herbert

(57) **Abstract**

A system (10) for cooling an electronics box (14) includes an electronics box (14) with a first portion (16) and a second portion (18). During a low load condition on the electronics box (14) the first portion (16) and the second portion (18) require a substantially similar amount of cooling air and during a high load condition on the electronics box the second portion (18) requires a substantially greater amount of cooling air than the first portion (16). The system further includes a first plenum (20) in fluid communication with the first portion (16) and a second plenum (22) in fluid communication with the second portion (18). A normal cooling air supply is in fluid communication with both the first plenum (20) and the second plenum (22) during the low load condition on the electronics box (14), and a supplemental cooling air supply in fluid communication with the second plenum (22) during the high load condition on the electronics box (14).

## Description

### BACKGROUND

The present embodiments relate generally to cooling of electronic devices, and in particular to cooling of electronic devices which have varying cooling needs within a single electronic device.

Electronic devices, and particularly large power electronic devices, dissipate heat and, therefore, require cooling to prevent overheating and potential failure of the electronic devices. The cooling needs of electronic devices can become more complicated when an electronic device operates in multiple modes at various times and thus dissipates varying levels of heat over time. For example, a backup converter can operate in a quiescent (i.e. dormant) mode where loads, and thus heat dissipations, are relatively low, yet when certain external conditions are triggered can operate in a high load condition where heat dissipations are relatively high. As a result, the cooling system for the backup converter must be thermally designed to handle peak loads on the backup converter when needed.

In addition, the cooling needs of electronic devices can be even further complicated when an electronic device is used in an application on an aircraft, where a supply of cooling air is limited. One prior solution to the cooling needs of an electronic device on an aircraft includes supplying a normal cooling air supply to the electronic device during a quiescent mode and supplying an additional supplemental cooling air supply to the electronic device during high load conditions. However, where an electronics device has distinct portions which dissipate differing levels of heat this prior cooling solution can lead to overcooling of one or more portions, wasting scarce cooling air.

### SUMMARY

One embodiment includes a system for cooling an electronics box where the system includes an electronics box with a first portion and a second portion. During a low load condition on the electronics box the first portion and the second portion require a substantially similar amount of cooling air and during a high load condition on the electronics box the second portion requires a substantially greater amount of cooling air than the first portion. The system further includes a first plenum in fluid communication with the first portion and a second plenum in fluid communication with the second portion. A normal cooling air supply is in fluid communication with both the first plenum and the second plenum during the low load condition on the electronics box, and a supplemental cooling air supply in fluid communication with the second plenum during the high load condition on the electronics box.

Another embodiment includes a method for cooling an electronics box where the method includes supplying a normal cooling air supply during a low load condition on the electronics box to both a first plenum in fluid communication with a first portion of the electronics box and a second plenum in fluid communication with a second portion of the electronics box. Loading on the electronics box is varied from the low load condition to a high load condition. A supplemental cooling air supply is supplied during the high load condition on the electronics box to the second plenum.

### BRIEF DESCRIPTION OF THE DRAWINGS

FIG. 1 is a cross-sectional illustration of an embodiment of a cooling system for an electronics box.
FIG. 2 is a cross-sectional illustration of another embodiment of a cooling system for an electronics box.
FIG. 3 is a cross-sectional illustration of an additional embodiment of a cooling system for an electronics box.
FIG. 4 is a cross-sectional illustration of a further embodiment of a cooling system for an electronics box.

While the above-identified drawing figures set forth multiple embodiments of the invention, other embodiments are also contemplated. In all cases, this disclosure presents the invention by way of representation and not limitation. It should be understood that numerous other modifications and embodiments can be devised by those skilled in the art, which fall within the scope and spirit of the principles of the invention. The figures may not be drawn to scale, and applications and embodiments of the present invention may include features and components not specifically shown in the drawings.

### DETAILED DESCRIPTION

The present embodiments provide systems and methods for supplying adequate cooling air to an electronics box, during all loading conditions on the electronics box, in an efficient manner which reduces the amount of cooling air needed.

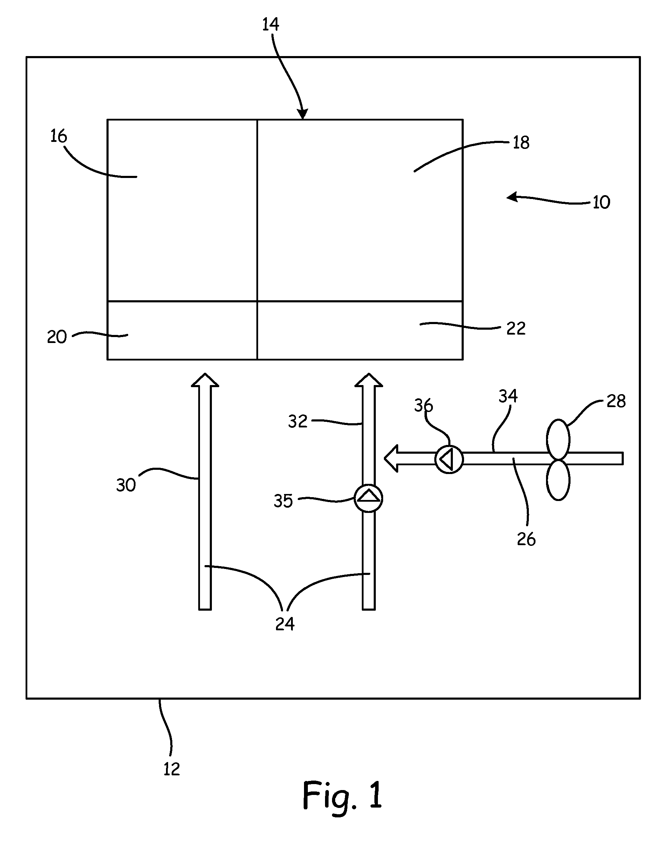

FIG. 1 shows a cross-sectional view of an embodiment of cooling system 10. One application of cooling system 10, for example, can be on aircraft 12. Cooling system 10 includes electronics box 14, which has first portion 16 and second portion 18, first plenum 20, second plenum 22, normal cooling air supply 24, and supplemental cooling air supply 26.

Electronics box 14 can be, for example, a backup converter, however, electronics box 14 of cooling system 10 can be any type of electronic device which experiences differing electrical (and as a result thermal) loads over time. The backup converter can be a large power electronic device, such as 50kVA, where heat dissipations approach 5kW. In one embodiment, the backup converter receives a power supply from a backup generator and outputs a constant frequency backup power supply for use by aircraft 12 during, for example, power outages to main power supply systems. Electronics box 14 operates over a range of various loading conditions, from a low load condition (e.g. quiescent mode, low heat dissipation) to a high load condition (e.g. peak operational mode, high heat dissipation).

Electronics box 14 includes both first portion 16 and second portion 18. First portion 16 can include, for example, control electronics and/or circuitry and second portion 18 can include, for example, power electronics such as semiconductors and magnetics. During the low load condition on electronics box 14, both portions 16 and 18 dissipate substantially similar amounts of heat, and thus require substantially similar amounts of cooling air. However, during the high load condition on electronics box 14 portion 18 dissipates an increased amount of heat over that during the low load condition, and therefore requires a substantially greater amount of cooling air than portion 16, which dissipates heat similar to that during the low load condition. In other embodiments, heat dissipation of portion 16 during the high load condition can increase over the amount of heat dissipation of portion 16 during the low load condition, while the increase in heat dissipation of portion 18 during the high load condition is greater than that of portion 16.

As illustrated in FIG. 1, first plenum 20 is in fluid communication with both first portion 16 and normal cooling air supply 24. Second plenum 22 is in fluid communication with second portion 18 as well as normal cooling air supply 24 and supplemental cooling air supply 26. In the illustrated embodiment, plenum 20 and plenum 22 are not in fluid communication, that is, a seal is present between them such that air from one plenum 20 or 22 does not leak to the other plenum 20 or 22. As shown in FIG. 1, plenums 20 and 22 are located beneath electronics box 14, however in other embodiments plenums 20 and 22 can be located in various positions such that plenum 20 is in fluid communication with portion 16 and plenum 22 is in fluid communication with portion 18.

Cooling system 10 operates to provide adequate cooling to electronics box 14 in an efficient manner during all loading conditions. During a low load condition on electronics box 14, normal cooling air supply 24 is fed to both first plenum 20 and second plenum 22. In the embodiment illustrated of FIG. 1, normal cooling air supply 24 is delivered to plenum 20 through conduit 30 and normal cooling air supply 24 is delivered to plenum 22 through conduit 32, which includes check valve 35 which allows normal cooling air supply 24 to pass into plenum 22 during the low load condition. Normal cooling air supply 24 can be, for example, air supplied from an electronic cooling or centralized cooling system of aircraft 12. Normal cooling air supply 24 fed into plenum 20 is then delivered into portion 16 and normal cooling air supply 24 fed into plenum 22 is then delivered into portion 18 to cool electronics box 14.

During a high load condition on electronics box 14, normal cooling air supply 24 is still fed to first plenum 20 through conduit 30, but supplemental cooling air supply 26 is now fed to second plenum 22 through fluidly connected conduits 32 and 34. Supplemental cooling air supply 26 can be, for example, air supplied from fan or fans 28 independent of normal cooling air supply 24. As previously explained, when electronics box 14 experiences a high load condition second portion 18 dissipates greater heat than first portion 16. This triggers fan 28 on, supplying supplemental cooling air 26 through check valve 36 of conduit 34 into conduit 32 and ultimately into plenum 22. When supplemental cooling air supply 26 is fed into conduit 32 during a high load condition, a back pressure from supplemental cooling air 26 in conduit 32 keeps check valve 35 closed, such that all cooling air supplied to plenum 22 is supplemental cooling air supply 26. To this end, check valve 35 is positioned upstream of the fluid connection between conduits 32 and 34. This allows for passive regulation of air supplies 24 and 26 without the need for powered, actively actuated valves, wiring, sensors, and the like. Also then a pressure in plenum 22 can be greater than a pressure in plenum 20. Supplemental cooling air supply 26 then passes from plenum 22 into second portion 18. As a result, because cooling system 10 provides supplemental cooling air supply 26 only to the portion (portion 18) of electronics box 14 which needs the extra cooling air, system 10 utilizes less cooling air in total as compared to prior cooling systems which supply additional cooling air to portions which do not need the additional cooling. Moreover, this is magnified when electronics box 14 is a higher power device such that prior cooling systems waste an even greater amount of cooling air.

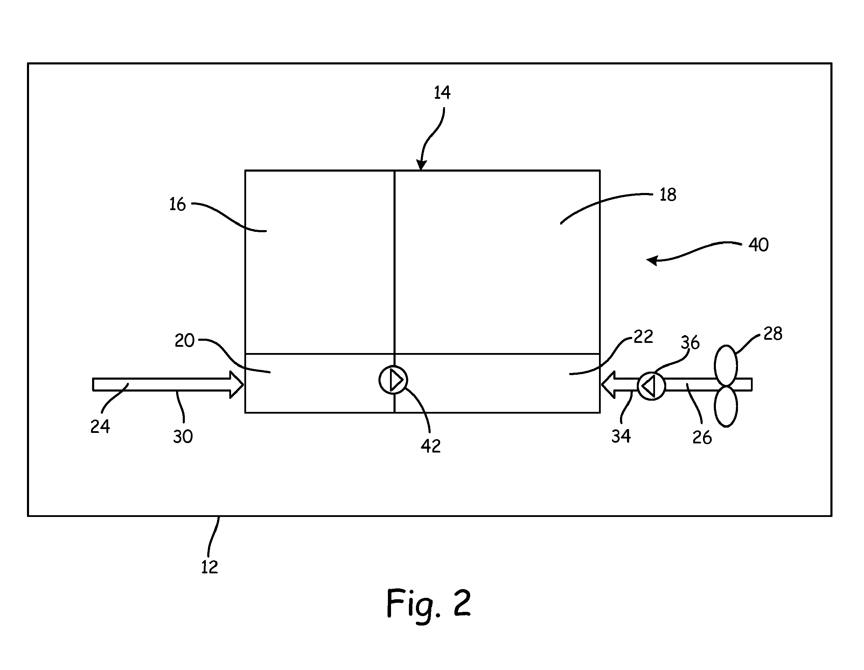

FIG. 2 shows a cross-sectional view of another embodiment of cooling system 40 for electronics box 14, similar to cooling system 10 described previously for FIG. 1. However, cooling system 40 supplies normal cooling air supply 24 to second plenum 22 through a different configuration. Cooling system 40 still feeds normal cooling air supply 24 into first plenum 20 through conduit 30 as was described previously, but cooling system 40 includes check valve 42 positioned between first plenum 20 and second plenum 22 such that plenums 20 and 22 are in fluid communication via check valve 42. As a result, at least a portion of normal cooling air supply 24 is supplied to second plenum 22 from first plenum 20 through check valve 42. Then, when electronics box 14 experiences a high load condition and second portion 18 dissipates greater heat than first portion 16, fan or fans 28 trigger on and supply supplemental cooling air 26 to plenum 22. As supplemental cooling air supply 26 is delivered to plenum 22, pressure in plenum 22 builds and back pressure prevents check valve 42 from delivering normal cooling air supply 24 into plenum 22 such that during the high load condition the only cooling air delivered to plenum 22 is supplemental cooling air 26. This again allows for passive regulation of air supplies 24 and 26 without the need for powered, actively actuated valves, wiring, sensors, and the like.

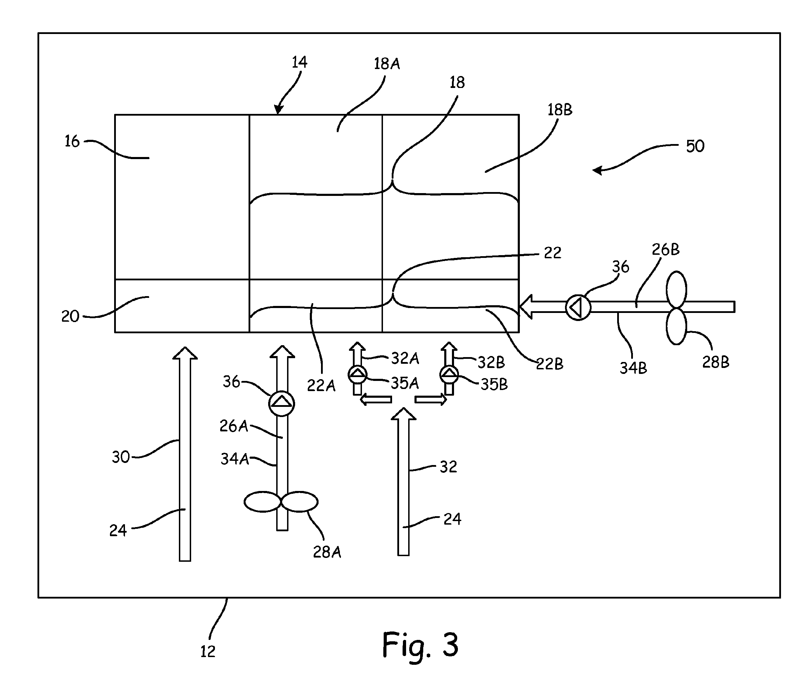

FIG. 3 illustrates a cross-sectional view of another embodiment of cooling system 50 for electronics box 14. In the illustrated embodiment, second portion 18 has separate subportions, first subportion 18A and second subportion 18B. Furthermore, plenum 22 is made up of separate subplenums 22A and 22B. Just as plenum 20 is in fluid communication with portion 16, subplenum 22A is in fluid communication with subportion 18A and subplenum 22B is in fluid communication with subportion 18B. During the low load condition on electronics box 14, normal cooling air supply 24 is fed to plenum 20 through conduit 30, while normal cooling air supply 24 is fed through conduit 32 to both conduits 32A and 32B such that normal cooling air supply 24 is delivered into subplenums 22A and 22B respectively. Conduits 32A and 32B include check valves 35A and 35B to ensure normal cooling air supply 24 travels in the proper direction.

Subportions 18A and 18B can dissipate differing amounts of heat during the high load condition. For example, first subportion 18A can be semiconductors and second subportion 18B can be magnetics which together make up power electronics of electronic box 14. Semiconductors can dissipate greater heat than magnetics during the high load condition on electronics box 14, and therefore can require a greater amount of cooling air.

To optimize the cooling needs of portion 18, a differing amount of supplemental cooling air 26 can be supplied to subportions 18A and 18B during the high load condition. Not only does this reduce the amount of total cooling air used by system 50, but can allow for optimal sized fans 28A and 28B to be utilized reducing a weight of system 50. To optimize cooling, system 50 has second plenum 22 divided up into first subplenum 22A and second subplenum 22B. When electronics box 14 is under a high load condition, fans 28A and 28B are switched on such that supplemental cooling air 26A is delivered into subplenum 22A through conduit 34A and supplemental cooling air 26B is delivered into subplenum 22B through conduit 34B. This allows a differing amount of supplemental cooling air 26A and 26B to be supplied to subplenums 22A and 22B via fans 28A and 28B, and therefore to subportions 18A and 18B which can require differing amounts of cooling. This can also allow for different pressures in subplenums 22A and 22B. Both conduits 34A and 34B include check valves 36 to ensure supplemental cooling air 26A and 26B travels in the proper direction. As supplemental cooling air 26A and 26B is delivered to subplenums 22A and 22B, pressures in subplenums 22A and 22B increase and back pressure prevents check valves 35A and 35B from opening and providing normal cooling air supply 24. This similarly allows for passive regulation of air supplies 24, 26A, and 26B without the need for powered, actively actuated valves, wiring, sensors, and the like.

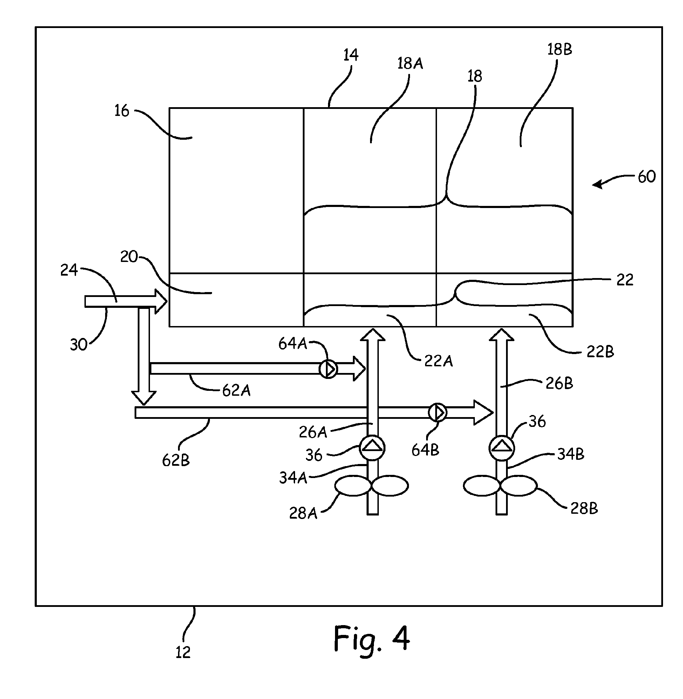

FIG. 4 shows a cross-sectional view of a further embodiment of cooling system 60. Cooling system 60 is similar to that described for cooling system 50 of FIG. 3. During a low load condition on electronics box 14, normal cooling air supply 24 pass through conduit 30 into plenum 20, while normal cooling air supply 24 is supplied to subplenums 22A and 22B from conduit 30 and conduits 62A and 62B respectively. Conduits 62A and 62B include check valves 64A and 64B which ensure cooling air travels in the proper direction. Supplemental cooling air supplies 26A and 26B are supplied to subplenums 22A and 22B similar to that described for system 50. Check valve 64A is positioned upstream, along conduit 62A, of the fluid connection between conduits 62A and 34A, and check valve 64B is positioned upstream, along conduit 62B, of the fluid connection between conduits 62B and 34B. This arrangement then allows the back pressure resulting from supplemental cooling air supply 26A and 26B to subplenums 22A and 22B to keep check valves 64A and 64B closed such that during the high load condition on electronics box 14 the only cooling air supplied to subplenums 22A and 22B is supplemental cooling air supply 26A and 26B respectively. System 60 similarly allows the cooling needs of subportions 18A and 18B to be optimized through the use of subplenums 22A and 22B in combination with supplemental cooling air supplies 26A and 26B. In a further embodiment of cooling system 60, instead of using conduits 62A and 62B to supply normal cooling air supply 24 to subplenums 22A and 22B, normal cooling air supply 24 can be fed from plenum 20 to subplenum 22A through a check valve located between plenums 20 and 22A and normal cooling air supply 24 can be fed from subplenum 22A to subplenum 22B through a check valve located between subplenums 22A and 22B.

### Discussion of Possible Embodiments

The following are non-exclusive descriptions of possible embodiments of the present invention.

A system for cooling an electronics box, the system comprising: an electronics box with a first portion and a second portion, wherein during a low load condition on the electronics box the first portion and the second portion require a substantially similar amount of cooling air and during a high load condition on the electronics box the second portion requires a substantially greater amount of cooling air than the first portion; a first plenum in fluid communication with the first portion; a second plenum in fluid communication with the second portion; a normal cooling air supply in fluid communication with both the first plenum and the second plenum during the low load condition on the electronics box; and a supplemental cooling air supply in fluid communication with the second plenum during the high load condition on the electronics box.

The system of the preceding paragraph can optionally include, additionally and/or alternatively, any one or more of the following features, configurations and/or additional components:
A check valve positioned between the first plenum and the second plenum, wherein the normal cooling air supply is in fluid communication with the first plenum through a conduit, and wherein at least a portion of the normal cooling air supply passes from the first plenum to the second plenum through the check valve.
A fan configured to provide the supplemental cooling air supply to the second plenum during the high load condition on the electronics box through a supplemental conduit fluidly connecting the fan to the second plenum.

The first portion comprises control electronics and circuitry and the second portion comprises power electronics.

During the high load condition on the electronics box a pressure in the second plenum is greater than a pressure in the first plenum.

The second portion comprises a first subportion and a second subportion, and wherein the second plenum comprises a first subplenum in fluid communication with the first subportion and a second subplenum in fluid communication with the second subportion.

The first subportion receives a greater amount of supplemental cooling air than the second subportion.

During the high load condition on the electronics box a pressure in the first subplenum is greater than a pressure in the first plenum and a pressure in the second subplenum is greater than the pressure in the first plenum.

A first fan configured to provide the supplemental cooling air supply to the first subplenum during the high load condition on the electronics box through a first supplemental conduit fluidly connecting the first fan to the first subplenum; and a second fan configured to provide the supplemental cooling air supply to the second subplenum during the high load condition on the electronics box through a second supplemental conduit fluidly connecting the second fan to the second subplenum.

The first fan provides a different amount of supplemental cooling air than the second fan.

A method for cooling an electronics box, the method comprising: supplying a normal cooling air supply during a low load condition on the electronics box to both a first plenum in fluid communication with a first portion of the electronics box and a second plenum in fluid communication with a second portion of the electronics box; varying loading on the electronics box from the low load condition to a high load condition; and supplying a supplemental cooling air supply during the high load condition on the electronics box to the second plenum.

The method of the preceding paragraph can optionally include, additionally and/or alternatively, the following techniques, steps, features and/or configurations:
Supplying a normal cooling air supply during a low load condition on the electronics box to both a first plenum in fluid communication with a first portion of the electronics box and a second plenum in fluid communication with a second portion of the electronics box comprises directing the normal cooling air supply into the first plenum and directing at least a portion of the normal cooling air supply from the first plenum to the second plenum through a check valve.
Supplying the supplemental cooling air supply to the second plenum stops the supply of the normal cooling air to the second plenum through pressurization of the second plenum by the supplemental cooling air.
Supplying the supplemental cooling air supply comprises supplying supplemental cooling air to both a first subplenum of the second plenum and a second subplenum of the second plenum.

The supplemental cooling air supplied to the first subplenum is supplied by a first fan and the supplemental cooling air supplied to the second subplenum is supplied by a second fan, and wherein the first fan and second fan supply differing amounts of supplemental cooling air.

Any relative terms or terms of degree used herein, such as "generally", "substantially", "approximately", and the like, should be interpreted in accordance with and subject to any applicable definitions or limits expressly stated herein. In all instances, any relative terms or terms of degree used herein should be interpreted to broadly encompass any relevant disclosed embodiments as well as such ranges or variations as would be understood by a person of ordinary skill in the art in view of the entirety of the present disclosure, such as to encompass ordinary manufacturing tolerance variations, incidental alignment variations, temporary alignment or shape variations induced by operational conditions, and the like.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims. For example, features described with respect to any given embodiment can be utilized with respect to any other disclosed embodiment, as desired for particular applications.

## Claims

1. A system (10;40;50;60) for cooling an electronics box (14), the system comprising:
an electronics box (14) with a first portion (16) and a second portion (18), wherein during a low load condition on the electronics box (14) the first portion (16) and the second portion (18) require a substantially similar amount of cooling air and during a high load condition on the electronics box (14) the second portion (18) requires a substantially greater amount of cooling air than the first portion;
a first plenum (20) in fluid communication with the first portion (16);
a second plenum (22) in fluid communication with the second portion (18);
a normal cooling air supply in fluid communication with both the first plenum (20) and the second plenum (22) during the low load condition on the electronics box (14); and
a supplemental cooling air supply in fluid communication with the second plenum (22) during the high load condition on the electronics box (14).

2. The system of claim 1, further comprising:
a check valve (42) positioned between the first plenum (20) and the second plenum (22), wherein the normal cooling air supply is in fluid communication with the first plenum (20) through a conduit (30), and wherein at least a portion of the normal cooling air supply passes from the first plenum (20) to the second plenum (22) through the check valve (42).

3. The system of claim 1 or 2, further comprising:
a fan (28) configured to provide the supplemental cooling air supply to the second plenum (22) during the high load condition on the electronics box (14) through a supplemental conduit (34) fluidly connecting the fan (28) to the second plenum (22).

4. The system of any preceding claim, wherein during the high load condition on the electronics box (14) a pressure in the second plenum (22) is greater than a pressure in the first plenum (20).

5. The system of claim 1, wherein the second portion (18) comprises a first subportion (18A) and a second subportion (18B), and wherein the second plenum (22) comprises a first subplenum (22A) in fluid communication with the first subportion (18A) and a second subplenum (22B) in fluid communication with the second subportion (18B).

6. The system of claim 5, wherein the first subportion (18A) receives a greater amount of supplemental cooling air than the second subportion (18B).

7. The system of claim 5 or 6, wherein during the high load condition on the electronics box (14) a pressure in the first subplenum (22A) is greater than a pressure in the first plenum (20) and a pressure in the second subplenum (22B) is greater than the pressure in the first plenum (20).

8. The system of any of claims 5 to 7, further comprising:
a first fan (28A) configured to provide the supplemental cooling air supply to the first subplenum (22A) during the high load condition on the electronics box (14) through a first supplemental conduit (34A) fluidly connecting the first fan (28A) to the first subplenum (22A); and
a second fan (28B) configured to provide the supplemental cooling air supply to the second subplenum (22B) during the high load condition on the electronics box (14) through a second supplemental conduit (34B) fluidly connecting the second fan (28B) to the second subplenum (22B).

9. The system of claim 8, wherein the first fan (28A) provides a different amount of supplemental cooling air than the second fan (28B).

10. The system of any preceding claim, wherein the first portion (16) comprises control electronics and circuitry and the second portion (18) comprises power electronics.

11. A method for cooling an electronics box (14), the method comprising:
supplying a normal cooling air supply during a low load condition on the electronics box (14) to both a first plenum (20) in fluid communication with a first portion (16) of the electronics box (14) and a second plenum (22) in fluid communication with a second portion (18) of the electronics box (14);
varying loading on the electronics box (14) from the low load condition to a high load condition; and
supplying a supplemental cooling air supply during the high load condition on the electronics box (14) to the second plenum (22).

12. The method of claim 11, wherein supplying a normal cooling air supply during a low load condition on the electronics box to both a first plenum (20) in fluid communication with a first portion (16) of the electronics box (14) and a second plenum (22) in fluid communication with a second portion (18) of the electronics box (14) comprises directing the normal cooling air supply into the first plenum (20) and directing at least a portion of the normal cooling air supply from the first plenum (20) to the second plenum (22) through a check valve (42).

13. The method of claim 11 or 12, wherein supplying the supplemental cooling air supply to the second plenum (22) stops the supply of the normal cooling air to the second plenum (22) through pressurization of the second plenum (22) by the supplemental cooling air.

14. The method of claim 11, wherein supplying the supplemental cooling air supply comprises supplying supplemental cooling air to both a first subplenum (22A) of the second plenum (22) and a second subplenum (22B) of the second plenum (22).

15. The method of claim 14, wherein the supplemental cooling air supplied to the first subplenum (22A) is supplied by a first fan (28A) and the supplemental cooling air supplied to the second subplenum (22B) is supplied by a second fan (28B), and wherein the first fan (28A) and second fan (28B) supply differing amounts of supplemental cooling air.
